# EUROPEAN PATENT APPLICATION

(11) **EP 1 959 028 A1**
(43) Date of publication of application: **20.08.2008**
(21) Application number: 07425078.8
(22) Date of filing: 13.02.2007
(51) Int. Cl.: C23C 14/35

(54) **Vacuum deposition system with mobile magnetron sputtering target**

(71) Applicant: Galileo Vacuum Systems S.p.A., 59100 Prato (IT)
(72) Inventor: Fanfani, Stefano, 50129 Firenze (IT)
(74) Representative: Mannucci, Michele

(57) **Abstract**

The vacuum deposition system comprises a vacuum chamber (3) with a bottom wall (3C), a side wall and a top wall (3B). In the vacuum chamber at least one magnetron (17) and at least one work-piece holder (9B) are arranged. The reciprocal distance between the work-piece holder and the magnetron is adjustable.

## Description

### Technical field

The present invention relates to sputtering systems for vacuum deposition that utilize one or more magnetrons, i.e. magnets that generate a magnetic field inside a vacuum chamber to accelerate particles of an inert gas, typically argon or nitrogen. These particles strike a target mounted on the magnetron and thereby cause the release of small particles of the material of which said target is made. These particles are deposited on the work-pieces to be metallized and which is paced inside the vacuum chamber on a specific work-piece holder that moves inside said chamber.

These vacuum deposition systems are used, for example, to metallize headlights or other plastic work-pieces.

### State of the Art

In conventional sputtering systems of this type the magnetrons are fitted to the side walls of the vacuum chamber, so that the lines to supply electricity and the cooling fluid required to maintain the electromagnets at a suitable temperature can pass through the walls of said chamber. The work-piece holder normally takes the form of a carousel arranged inside the chamber with the magnetrons positioned laterally with respect to the carousel.

These conventional systems have a series of drawbacks and limitations. In particular, the position of the magnetrons can interfere with the door of the vacuum chamber, and therefore they must be placed at a certain angle with respect to the axis of rotation of the work-piece supporting carousel, said angle being not necessarily optimal from the viewpoint of treatment of the work-pieces. Moreover, the need to place the magnetrons close to the inner wall of the chamber makes it difficult to access the rear part thereof, in which the screws that hold the targets attached to the front side of the magnetrons in place are positioned. This makes maintenance operations and the operations to replace the targets difficult.

Moreover, it is not possible to modify the distance between the work-pieces carried by the work-piece holder and the magnetrons with the respective targets.

### Object and summary of the invention

According to a first aspect, one object of the invention is to provide a deposition system of the type indicated above, in which it is possible to utilize a further processing parameter allowing greater operational flexibility of the system.

In substance, this further degree of freedom or process parameter is represented by the reciprocal distance between one or more work-piece holders disposed inside the vacuum chamber and the magnetron(s) arranged in said chamber. In fact, according to this aspect, the magnetron(s) has/have a variable distance with respect to the work-piece holders, said variability being obtainable by mounting the magnetron(s) in an adjustable position and/or adjusting the position of the work-piece holder(s) inside the vacuum chamber. In a preferred embodiment, the work-piece holder is placed in a fixed position and the magnetron(s) is/are adjustable.

The object of an improved embodiment of the invention is to provide a vacuum deposition system of the aforesaid type, in which maintenance and other operations on the machine are easier to perform. According to an improved embodiment of the invention, the magnetron(s) is/are supported by the top wall of the chamber and extend(s) longitudinally towards the bottom wall or base of said chamber. Moreover, advantageously it is possible for the magnetron(s) to be movable with respect to the walls of the vacuum chamber to move towards and away from the side walls. This arrangement allows greater access to the rear part of the magnetrons and consequently considerably facilitates maintenance operations, such as disassembling used targets and mounting new targets, cleaning, repairs to the electrical and hydraulic circuit parts of the magnetrons, and the like. For this purpose, the magnetrons can advantageously be moved away from the side walls of the chamber towards the central axis, thereby facilitating access to the rear part of said magnetrons.

The arrangement of the magnetrons on the top wall of the of the chamber and movable with respect thereto also allows the production of a vacuum chamber with improved geometry. The arrangement of the magnetrons supported by the top wall of the chamber allows said magnetrons to be positioned with a symmetrical geometry with respect to the axis of rotation of the work-piece holder. In fact, chambers of this type have a wide frontal door or, more frequently, pairs of doors that are open and closed alternately and each of which supports a work-piece holder in the form of a rotating carousel. In conventional solutions, where the magnetrons are carried by the side walls of the chamber, these cannot be disposed on a plane containing the axis of rotation of the work-piece carousel, as the side wall of the chamber is divided into a fixed part and a movable part defining the door. The movable part has a wide angular extension, so that the magnetrons, which must be supported in the fixed part, must be disposed staggered angularly from one another by less than 180°. An asymmetrical and less than optimal geometry for treatment of the work-pieces is obtained.

According to the invention, by positioning the magnetrons on the top wall of the chamber this drawback is avoided and the magnetrons can be disposed with an alignment of 180° to obtain a symmetrical geometry of the chamber and of the magnetic fields generated by the magnetrons therewithin. This is particularly advantageous as the work-pieces on the work-piece carousel are positioned according to alignments staggered by 180° or 90° from one another around the circumferential extension of the work-piece supporting carousel. The work-piece supporting carousel therefore rotates at steps with an angle of 180° or 90° depending on the number of rows of work-pieces mounted thereon. By disposing the magnetrons at 180° it is possible to arrange sequentially each row of work-pieces in front of the magnetron and therefore obtain a faster vacuum deposition treatment with a greater hourly flow rate of deposition material on the work-pieces.

Further advantageous characteristics and embodiments of the vacuum deposition system according to the invention are indicated in the appended claims and will be described in greater detail hereunder with reference to non-limiting embodiments of the invention.

### Brief description of the drawings

The invention will be better understood by the following description and accompanying drawings, which show non-limiting embodiment of the invention. More specifically, in the drawing:
Fig.1 shows a side view of a system in which the invention can be embodied;
Figure 2 shows a plan view according to II-II in Figure 1;

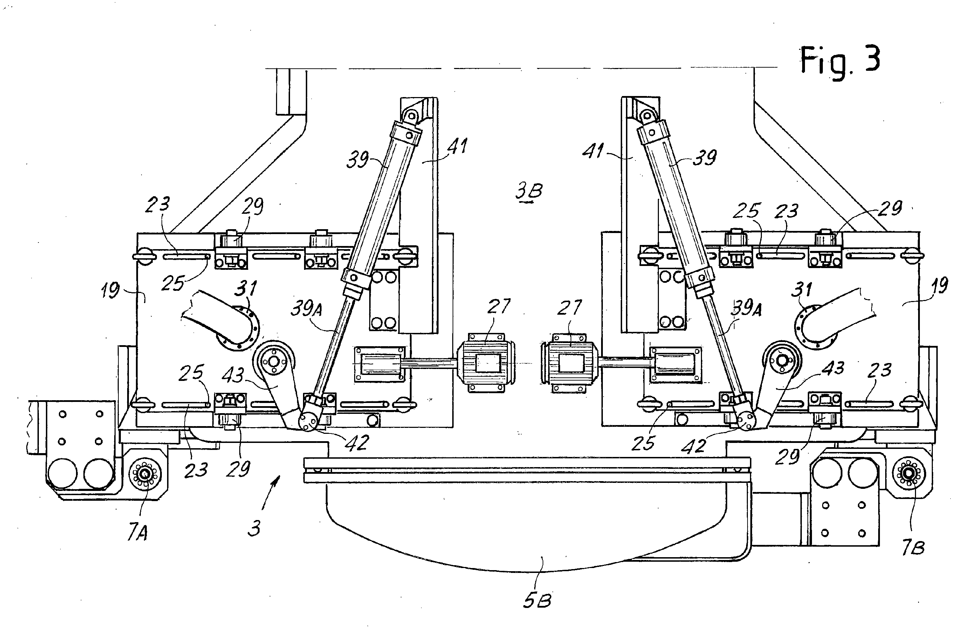

Figure 3 shows a plan view of a detail of the top part of the vacuum deposition chamber;
Figure 4 shows a partially sectional detail of Figure 3;
Figure 5 shows a section of the top part of the vacuum chamber according to V-V in Figure 4;
Figures 6 and 7 show a schematic plan view of vacuum chambers in modified embodiments, with the top part removed.

### Detailed description of embodiments of the invention

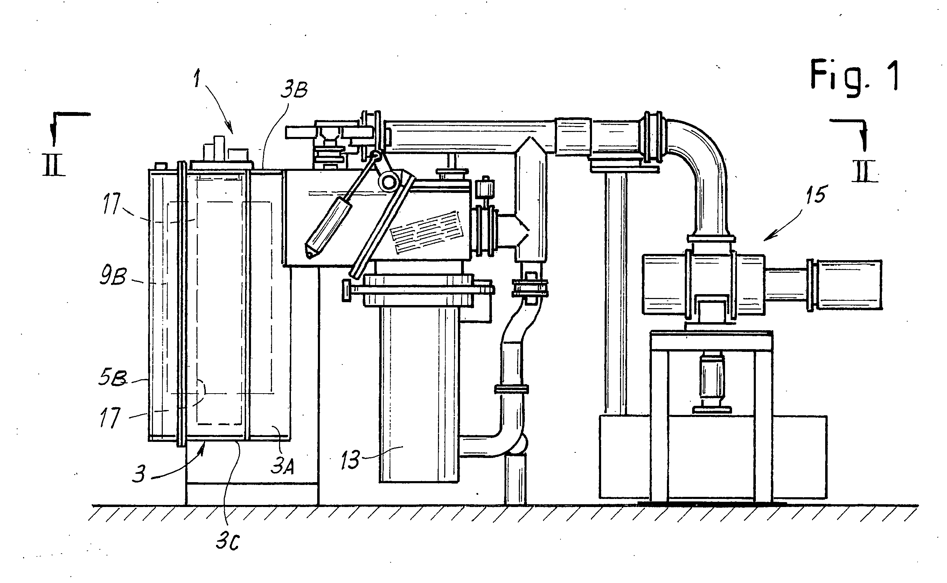

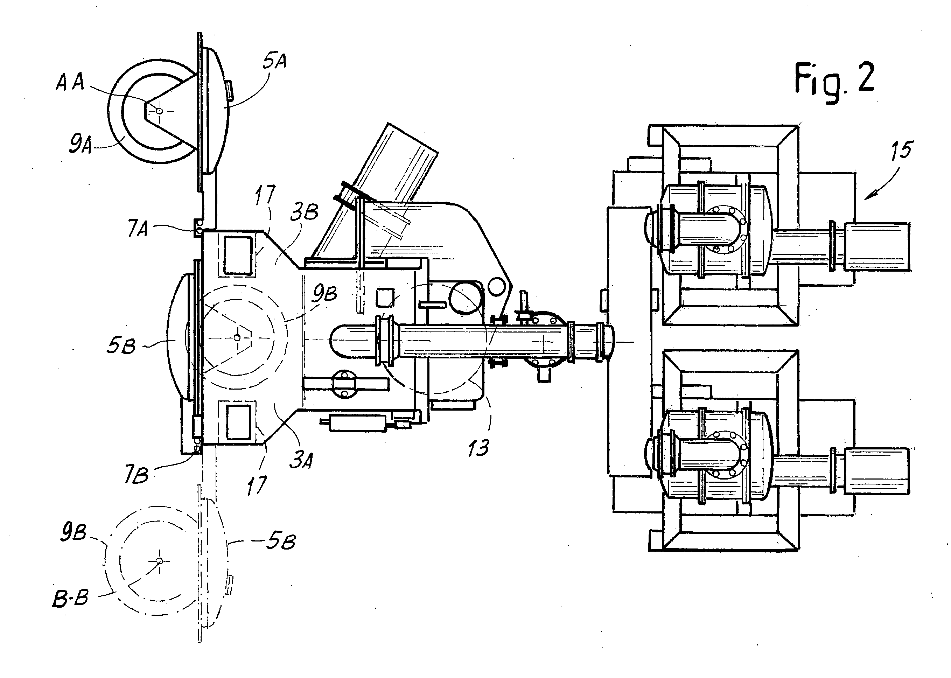

With initial reference to Figures 1 and 2, in one embodiment the vacuum deposition system, indicated as a whole with 1, has a vacuum chamber 3 with a pair of doors 5A and 5B hinged in 7A and 7B to a fixed part 3A of the chamber. The fixed part of the vacuum chamber generally comprises a side wall, a top wall 3B and a bottom wall 3C. The side wall can be constituted by a circular or prismatic wall or by a combination of cylindrical and prismatic or flat portions, intersecting along substantially vertical edges.

In a different embodiment, not shown, the system comprises a single door, rather than two doors. In one embodiment the door(s) is/are hinged to the fixed part of the chamber by a single or double axis hinge. In an alternative embodiment, not shown, the door(s) can be constrained to the vacuum chamber, or more specifically to the fixed part or wall thereof, by means of a different type of constraint, such as a sliding system or the like.

In an advantageous embodiment, the vacuum deposition system comprises a first work-piece supporting carousel 9A rotating about an axis A-A carried by the door 5A, while a second symmetrical work-piece supporting carousel 9B is supported rotating about an axis B-B by the door 5B. As can be seen in particular in Figure 2, by closing one or other of the doors 5A, 5B, the respective carousel 9A or 9B is disposed inside the vacuum chamber 3 with the axis thereof in a substantially central position with respect to said chamber, defined by the fixed portion 3A and by the door 5A or 5B which is closed time by time. In Figure 2 the door 5B is shown with a solid line in the closed position and with a broken line in the open position, while the door 5A is in the open position to allow the operator to remove any work-pieces processed in the previous cycle from the work-piece supporting carousel 9A and reload it with new work-pieces to be treated in the subsequent cycle.

Pumps and other devices known per se are associated with the vacuum chamber 3 to create the correct degree of vacuum required in each step of the deposition cycle inside the chamber 3 and also to feed into said chamber process gases, for example an inert gas like nitrogen or argon, during the deposition step and monomers during the step to form a polymer film to protect deposition. Reference number 13 generically indicates a diffusion pump and reference number 15 a group of mechanical pumps to produce the necessary degree of vacuum inside the chamber 3. The details of this part of the system are not described as they are known to those skilled in the art and in any case are not critical in order to understand the present invention.

In an advantageous embodiment, the vacuum chamber has a top wall 3B, opposite a bottom wall or base 3C and on which there are supported two magnetrons 17 which extend from the top wall 3B downward, i.e. towards the bottom wall 3C, parallel to the axis of rotation of the work-piece supporting carousel 9A or 9B that is disposed time by time inside the vacuum chamber 3.

In one embodiment, each magnetron 17 is supported on a slide or plate 19 mounted on the outside of the top wall 3B of the chamber 3. It would also be possible to dispose the slide 19 inside the chamber 3. In one embodiment, a seal 21 with rectangular extension is disposed between the plate or slide 19 and the wall 3B to surround an opening 3E of the top wall 3B, provided under the plate 19. The width of the opening 3E is approximately equivalent to the width of the rectangular area defined by the seal 21, while the length of the opening 3E is substantially less than the length of the rectangular area delimited by said seal 21, so that when the plate 19 translates according to the double arrow f19 parallel to the direction of the longer side of the opening 3E, the latter always remains under the plate 19 and inside the area delimited by the seal 21.

In one embodiment, guide slots 23 are provided on the plate 19, in which there are inserted pins 25 integral with the top wall 3B of the vacuum chamber 3. The slots 23 and the pins guide the movement according to f19 of the plate or slide 19 along the top wall 3B of the chamber. In one embodiment, the movement according to f19 of each plate 19 is imparted by a respective electric motor 27, through a screw-nut screw coupling, or through another suitable actuation device, such as a piston-cylinder actuator, a hydraulic motor or the like. In one embodiment, a single electric motor 27 can be provided, which for example controls a threaded bar with two oppositely threaded portions, to simultaneously move towards or away from each other with specular movements the two plates or slides, each of which has a respective nut screw engaged with one or other of the two threaded portions of the bar. The movement according to f19 of each plate or slide 19 is preferably performed by first lifting the plate with respect to the top surface of the wall 3B, so that the seal 21 does not rub on the wall during the movement. For this purpose, side rollers 29 can be provided, which are mounted idle on an eccentric that is rotated to lower the axis of rotation of the rollers 29 and consequently lift the plate 19 from the top wall 3B of the chamber.

The plate 19 has a through hole 31 for the power and service cables to the underlying magnetron 17 supported by said plate 19. The through hole 31 is utilized for passage of the electrical power cables and also for the pipes of the water or other cooling fluid required to maintain the respective magnetron 17 at a controlled temperature or in any case to cool it.

As can be easily understood from the description above, by adjusting the position of each of the two plates 19 on the surface of the top wall 3B according to f19, this arrangement allows adjustment of the distance between the magnetrons 17 located inside the vacuum chamber and consequently adjustment of the reciprocal distance between the magnetrons and the work-piece supporting carousel 9A or 9B which is positioned time by time inside the vacuum chamber 9. Adjustment takes place before the vacuum is created inside the chamber, as this allows the plate 19 to be easily lifted from the upper surface of the top wall 3B of the chamber. After reaching the desired position of the magnetron 17, the plate or slide 19 carrying each of the two magnetrons 17 is lowered and the degree of vacuum required for the subsequent deposition cycle is created inside the vacuum chamber 3.

In a modified embodiment, not shown, the slide or plate 19 carrying the magnetron could be mounted inside the vacuum chamber, i.e. under the top wall 3B, for example using suitable sliding guides and the movement could be provided by a motor or other suitable actuator, again preferably arranged on the outside of the vacuum chamber. A suitable through hole is used in this case, for example, to allow entry, through the wall of the vacuum chamber, of a threaded bar or other member that imparts the translational movement to the respective plate 19 carrying the magnetron 17. In this case the motor could be supported on the side wall 3D of the chamber or even on the top wall 3B with a suitable side transmission.

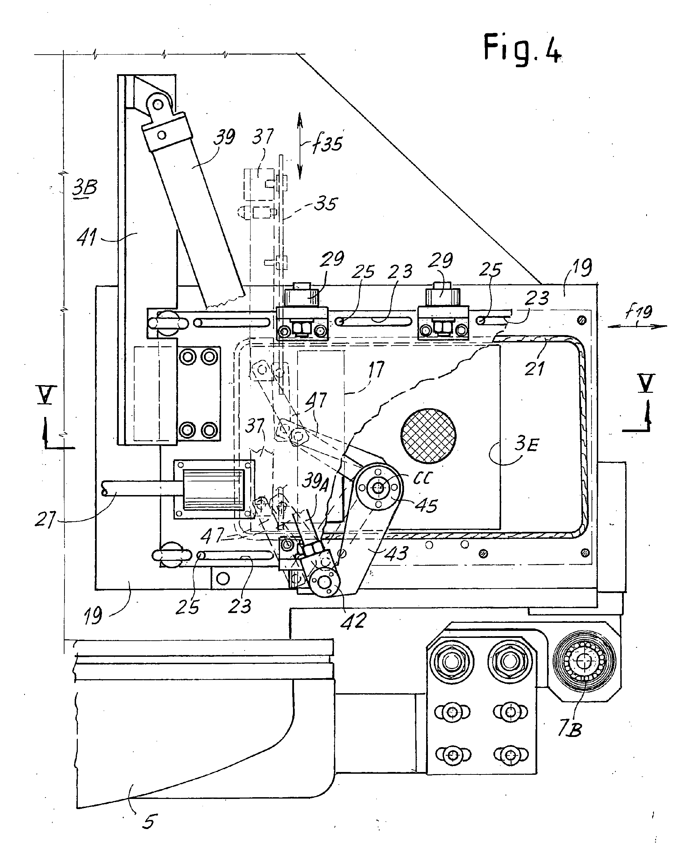

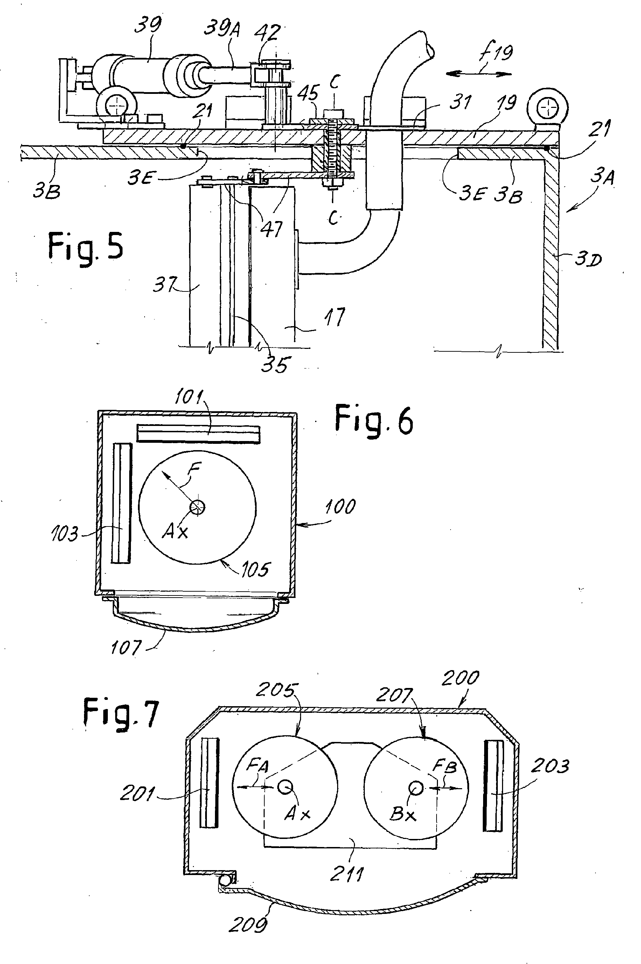

In one embodiment of the invention, a protective shield is associated with each magnetron 17 (see in particular Figures 4 and 5), movable according to the double arrow f35, for this purpose guided, for example, by a guide 37 integral with the respective plate 19. In one embodiment, the movement according to f35 is imparted to the shield 35 by a piston cylinder actuator 39 mounted on the outside of the vacuum chamber, preferably above the plate or slide 19, with the aid of a bracket 41. The rod 39A of the piston-cylinder actuator 39 is hinged in 42 to an oscillating arm 43, which by means of a through hole 45 transmits the rotational motion about an axis C-C to a linkage 47 with which the protective shield 35 is carried, through a movement according to f35, alternately to a lateral position with respect to the magnetron 17 or to a position in front of said magnetron, to protect the target mounted on the magnetron 17. By arranging the piston-cylinder actuator 39 on the plate or slide 19 it travels together therewith in the movement to adjust the respective magnetron 17 inside the vacuum chamber 3.

A movement according to f35 of the shield 35 allows the latter to be positioned in front of the target mounted on the respective magnetron 17, for example in the polymerization treatment steps of work-pieces on which metallization or other deposition of materials has been carried out by means of sputtering. In fact, in the polymerization step, monomers are, for example, fed into the vacuum chamber through suitable gas distributors; these monomers deposit on the metallized surfaces of the work-pieces and cross-link to produce a polymeric protection. These monomers must not soil the surface of the targets and for this purpose the protective shield 35 is placed in front of the exposed surface of said targets. The protective shields 35 can also be used in the work-piece cleaning step, which precedes the vacuum deposition step, and which also takes place by introducing suitable process gases.

In a different embodiment, not shown, the protective shield 35 can be provided with only the movement between a position covering the magnetron or the relative target and a withdrawn position, in which the target and the magnetron are freely facing towards the work-piece holder. In this case, the shield does not follow the translational movement with which the respective magnetron moves toward or away from the work-piece holder. In this case the system can be controlled so that the magnetron is always carried to a specific position, such as the position of maximum distance from the axis of the vacuum chamber, when it has to be protected by the shield 35.

In a different embodiment, not shown, the protective shield 35 and the respective magnetron can both be movable in a coordinated manner, but supported on different supports, for example on two distinct slides. Each of the two slides can be controlled by its own independent actuator. In one embodiment, one actuator can be provided to control with specular movements two slides or plates on which the magnetrons are mounted and a different actuator can be provided to control with specular movements two slides or plates on which the protective shields are mounted. Alternatively, a single actuator can move, for example by means of a common threaded bar, two slides one carrying the magnetron and one carrying the protective shield. Also in this case, a threaded bar with two oppositely threaded portions can be provided to move both shields and both magnetrons with specular movements.

With the arrangement described above it is possible to adjust the reciprocal distance between the two magnetrons 17 and consequently between these and the work-piece supporting carousel 9A or 9B which is inserted time by time inside the vacuum chamber 3. This possibility of adjustment provides the system with a further adjustable process parameter in addition to those with which these machines are normally provided. Moreover, by moving the two magnetrons 17 towards each other, i.e. moving them towards the axis of the vacuum chamber 3, access to the rear side is facilitated, making it easier to perform any maintenance operation and also to replace the target which is normally secured on each magnetron 17 with screws accessible from the rear area of said magnetron.

As can be observed in particular in Figure 2, the conformation of the system also allows the magnetrons 17 to be disposed at 180° with respect to the axis of rotation of the work-piece supporting carousel 9A or 9B, without interfering with the door 5B or 5A, due to the fact that the magnetrons 17 are supported by the top wall 3B.

The embodiment described above provides for positioning of a single work-piece holder at a time in the vacuum chamber. Nonetheless, it would also be possible for two or more work-piece holders to be positioned simultaneously in the vacuum chamber.

At least some of the advantages described above are also obtained in a different embodiment (Figure 6) in which the magnetrons are fixed with respect to the vacuum chamber, while the work-piece holder is adjustable in position. In this embodiment, the vacuum chamber is indicated with 100 while the numbers 101 and 103 schematically indicate the two magnetrons which extend vertically from the top downwards and are supported, for example, by the top wall or by the side walls of the chamber 100. The number 105 indicates a work-piece supporting carousel and the number 107 a door to close the vacuum chamber 100. The arrow F indicates the direction of adjustment of the position of the axis Ax of the work-piece supporting carousel 105 with respect to the magnetrons 101 and 103. Also in this case there is the advantage of obtaining a further adjustable process parameter, represented by the distance between the work-piece supporting carousel 105 (and the work-pieces to be treated placed thereon) and the magnetrons 101, 103. In this embodiment, the advantages deriving from the mobility of the magnetrons 101, 103 with respect to the walls of the vacuum chamber 100 and in particular easier access to the rear area of each magnetron 101, 103, are not achieved.

In a further embodiment (Figure 7) inside a vacuum chamber 200 there are disposed two magnetrons 201 and 203 placed opposite each other. Between the two magnetrons two work-piece supporting carousels 205, 207 are arranged, the axes of rotation of which are indicated with Ax and Bx. The number 209 indicates a door to close the vacuum chamber and 211 a common support of the two work-piece supporting carousels 205, 207. Each carousel 205, 207 is adjustable by means of a specific supporting and guiding system, not shown, so that the axes Ax, Bx of the carousels 205 and 207 can move towards and away from the magnetrons 201 and 203 respectively, according to the arrows FA, FB. Also in this case, just as in the previous embodiment illustrated, the advantage of adjustability of the distance between the work-pieces to be treated and the magnetrons 201, 203 is obtained, although the considerable advantage of increased accessibility of the rear area of each magnetron 201, 203 for easier maintenance and repairs when required is not achieved.

It is understood that the drawing only shows an example provided purely as a practical arrangement of the invention, which can vary in forms and arrangement without however departing from the scope of the concept underlying the invention. Any reference numbers in the appended claims are provided for the purpose of facilitating reading of the claims with reference to the description and to the drawing and do not limit the scope of protection represented by the claims.

## Claims

1. A vacuum deposition system comprising a vacuum chamber with a bottom wall, a side wall and a top wall, wherein at least one magnetron is arranged in the vacuum chamber and wherein at least one work-piece holder is positionable in said chamber, **characterized in that** the reciprocal distance between said work-piece holder and said magnetron is adjustable.

2. A system as claimed in claim 1, **characterized in that** said at least one magnetron is supported by the top wall of said chamber and extends according to a longitudinal direction towards the bottom wall of the chamber.

3. A system as claimed in claim 2, **characterized in that** said at least one magnetron is movable with respect to the walls of the vacuum chamber.

4. A system as claimed in claim 3, **characterized in that** said at least one magnetron is movable substantially horizontally in a substantially vertical plane to move towards and away from a central axis of the chamber.

5. A system as claimed in claim 3, **characterized in that** it comprises two magnetrons, both supported by said top wall of the chamber and movable with respect to the walls of the chamber.

6. A system as claimed in claim 5, **characterized in that** when the chamber is closed said two magnetrons are arranged on opposite sides of said work-piece holder inserted in the vacuum chamber.

7. A system as claimed in one or more of the previous claims, **characterized in that** said work-piece holder rotates about a substantially vertical axis of rotation, approximately parallel to a longitudinal extension of said at least one magnetron, which can translate to move towards and away from said axis of rotation.

8. A system as claimed in claim 6, **characterized in that** said work-piece holder rotates about a substantially vertical axis of rotation, approximately parallel to a longitudinal extension of said magnetrons, which are arranged in approximately symmetrical positions with respect to said axis of rotation.

9. A system as claimed in claim 5, 6 or 8, **characterized in that** said magnetrons are movable substantially horizontally in a substantially vertical plane.

10. A system as claimed in claim 5, 6, 8 or 9, **characterized in that** said two magnetrons are movable substantially horizontally along substantially radial directions with respect to a substantially vertical central axis of the vacuum chamber.

11. A system as claimed in one or more of claims 5, 6, 8, 9 or 10, **characterized in that** said two magnetrons are movable along a common direction.

12. A system as claimed in one or more of the previous claims, **characterized in that** said at least one magnetron is carried by a supporting member movably coupled to the vacuum chamber.

13. A system as claimed in claim 12, **characterized in that** said support is slidingly coupled to a wall of the vacuum chamber.

14. A system as claimed in claim 13, **characterized in that** said support is coupled to the top wall of the vacuum chamber.

15. A system as claimed in claim 14, **characterized in that** said support is placed on the outside of the vacuum chamber.

16. A system as claimed in one or more of the previous claims, **characterized in that** said at least one magnetron is carried by a slide movably supported by the top wall of the vacuum chamber.

17. A system as claimed in claim 16, **characterized in that** said slide is disposed on the outside of the vacuum chamber and **in that** a seal is provided between the slide and the top wall of the chamber.

18. A system as claimed in one or more of the previous claims, **characterized in that** said vacuum chamber comprises a fixed side wall, associated with which is at least one closing door combined with a work-piece holder.

19. A system as claimed in claim 18, **characterized in that** said work-piece holder is supported by said door.

20. A system as claimed in one or more of the previous claims, **characterized in that** it comprises two doors associated with a fixed side wall, which are moved alternately to the closed position.

21. A system as claimed in claim 20, **characterized in that** each door is associated with a work-piece holder.

22. A system as claimed in one or more of claims 18 to 21, **characterized in that** said or each of said work-piece holders rotates about a respective axis substantially parallel to a hinge axis about which the respective door pivots to open and close.

23. A system as claimed in one or more of the previous claims, **characterized in that** each said magnetron is associated with a movable protective shield to be carried in front of the magnetron or of a target mounted on the magnetron to protect it during one or more steps of a process carried out in said system.

24. A system as claimed in claim 23, **characterized in that** said movable protective shield is provided with a movement coordinated with the movement of the respective magnetron.

25. A system as claimed in claim 23, **characterized in that** said protective shield is carried by a movable support to follow the movement of the respective magnetron.

26. A system as claimed in claim 24 or 25, **characterized in that** each magnetron and the respective protective shield are mounted on a common supporting slide.

27. A system as claimed in claim 27, **characterized in that** said slide is disposed movably on the top wall of said chamber.

28. A system as claimed in claim 1 or 2, **characterized in that** said at least one magnetron is fixed with respect to the vacuum chamber and said at least one work-piece holder is adjustable with respect to the magnetron to take a variable distance with respect to the magnetron during the vacuum deposition cycle.

29. A system as claimed in claim 28, **characterized in that** it comprises two magnetrons disposed at approximately 90° with respect to an axis of said work-piece holder, the work-piece holder being adjustable to move towards or away from said magnetrons.
